# EUROPEAN PATENT APPLICATION

(11) **EP 4 549 525 A1**
(43) Date of publication of application: **07.05.2025**
(21) Application number: 24209606.3
(22) Date of filing: 29.10.2024
(51) Int. Cl.: C09G 1/02, C09K 3/14, H01L 21/3105, H01L 21/321

(54) **POLISHING COMPOSITION FOR SEMICONDUCTOR PROCESS AND METHOD OF MANUFACTURING SUBSTRATE USING THE SAME**

(30) Priority: 02.11.2023 KR 20230149898
(71) Applicant: SK enpulse Co., Ltd., Pyeongtaek-si, Gyeonggi-do 17784 (KR)
(72) Inventor: HAN DEOK, Su, 03142 Seoul (KR)
(74) Representative: BCKIP Part mbB

(57) **Abstract**

The polishing composition for semiconductor processing includes abrasive particles and a first metal ion, which is an alkali metal ion, wherein the abrasive particles have surface positive charges, and wherein an amount of the first metal ion is 15 ppm (by weight) to 100 ppm (by weight).

## Description

This application claims the priority benefit of Korean Patent Application No. 10-2023-0149898 filed on November 6, 2023 in the Korean Intellectual Property Office.

### BACKGROUND

### 1. Field

The present disclosure relates to a polishing composition for semiconductor process and a method of manufacturing substrates using the same.

### 2. Description of the Background

As semiconductor devices become more miniaturized and denser, finer patterning techniques are being used, resulting in more complex surface structures and larger gaps between layers. In manufacturing semiconductor devices, chemical mechanical polishing (hereinafter referred to as "CMP") is used as a planarization technique to eliminate the gaps in certain films formed on the substrate.

In the CMP process, a substrate is pressurized and rotated, while a slurry is applied to a polishing pad, and the surface thereof is polished. Depending on the stage of the process, the object to be flattened varies and the properties of the slurry applied thereto also vary.

Polishing after the metal wiring is formed requires sufficient polishing rate and polishing speed while minimizing dishing or erosion.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

In one general aspect, the polishing composition for semiconductor processing includes abrasive particles and a first metal ion, which is an alkali metal ion, wherein the abrasive particles have surface positive charges, and wherein an amount of the first metal ion is 15 ppm (by weight) to 100 ppm (by weight).

The alkali metal ion may be monovalent ion selected from the group consisting of lithium ions, sodium ions, potassium ions, rubidium ions, cesium ions, and francium ions.

The polishing composition may further include a second metal ion selected from the group consisting of iron ions, copper ions, nickel ions, aluminum ions, calcium ions, and zinc ions.

A ratio of an amount (by weight) of the second metal ion to the amount (by weight) of the first metal ion may be 15 or more.

The abrasive particles may have a zeta potential of +10 mV to +50 mV at a pH of 2 to 5.5.

The abrasive particles may be surface-modified with a compound having an amine group.

The abrasive particles may be surface-modified with a compound having an amino silane selected from the group consisting of 3-aminopropyltriethoxysilane, bis[(3-triethoxysilyl)propyl]amine, 3-aminopropyltrimethoxysilane, bis[(3-trimethoxysilyl)propyl]amine, 3-Aminopropylmethyldiethoxysilane, 3-Aminopropylmethyldimethoxysilane, N-[3-(trimethoxysilyl)propyl]ethylenediamine, N-bis[3-(trimethoxysilyl)propyl]-1,2-ethylenediamine, N-[3-(triethoxysilyl)propyl]ethylenediamine, diethylenetriaminopropyltrimethoxysilane, diethylenetriaminopropylmethyldimethoxysilane, diethylaminomethyltriethoxysilane, diethylaminopropyltrimethoxysilane, diethylaminopropyltriethoxysilane, dimethylaminopropyltrimethoxysilane, and N-[3-(trimethoxysilyl)propyl]butylamine.

The polishing composition may include the abrasive particles in an amount of 1 wt% to 10 wt% based on a total weight of the polishing composition.

The abrasive particles may have an average particle diameter of 20 nm or more.

The polishing composition may have an electrical conductivity of 10 µS/cm to 300 µS/cm.

The polishing composition may further include a fluorinated surfactant.

The fluorinated surfactant may be a fluoroalkyl alkylene oxide-based compound of Formula 1:

[Formula 1]. R_{f}-(Rₑₙ-O)ₙ-H

In Formula 1 above, R_{f} may be a fluoroalkyl group having a carbon number from 3 to 10, Rₑₙ may be an alkylene group having a carbon number from 2 or 3, and n may be an integer from 2 to 15.

The polishing composition may include 10 ppm (by weight) to 500 ppm (by weight) of the fluorinated surfactant.

The polishing composition may have a viscosity of 0.8 cP to 2.0 cP at 25°C.

The fluorinated surfactant may have a weight average molecular weight of 150 g/mol to 3,000 g/mol.

The polishing composition may further include an additive selected from the group consisting of an oxidizing agent, an acid component, a pH modifier, a chelating agent, a dispersant, a polishing rate enhancer, a polishing modifier, a polishing pad protector, and a preservative.

In another general aspect, the method of manufacturing a substrate includes polishing the substrate by applying the above polishing composition as a slurry.

The polishing may include: contacting the substrate with a polishing pad and the polishing composition described above supplied from a spray nozzle; and rotating a polishing head fixing the substrate and a platen, to which the polishing pad is attached.

During the polishing, a pressure of 6.89 kPa to 48.26 kPa may be applied to the substrate.

The substrate may include at least one of an insulating film, metallized wiring, and a barrier layer.

Other features and aspects will be apparent from the following detailed description and the claims.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of this disclosure. For example, the sequences of operations described herein are merely examples, and are not limited to those set forth herein, but may be changed as will be apparent after an understanding of this disclosure, with the exception of operations necessarily occurring in a certain order. Also, descriptions of features that are known in the art may be omitted for increased clarity and conciseness.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of this disclosure. Hereinafter, while embodiments of the present disclosure will be described in detail, it is noted that examples are not limited to the same.

As used herein, the terms "about," "substantially," and the like are meant to be used at or near the numerical value when manufacturing and material tolerances inherent in the recited meanings are presented, and to aid in the understanding of the embodiments, and to prevent unscrupulous infringers from taking unfair advantage of the disclosure where precise or absolute numerical values are recited.

Throughout the disclosure, the term "combination thereof" as used in a Makushi-style representation means one or more mixtures or combinations selected from the group of components described in the Makushi-style representation, including one or more selected from the group of components.

Throughout the disclosure, references to "A and/or B" shall mean "A, B, or A and B".

Throughout the disclosure, terms such as "first", "second" or "A", "B" are used to distinguish one from the other unless otherwise indicated.

As used herein, the reference to B being located on A means that B is or may be located on A with other layers located therebetween, and is not to be construed as limited to B being located abutting the surface of A.

In the disclosure, singular expressions shall, unless otherwise indicated, be construed to include the singular or plural as construed from the context.

Hereinafter, a detailed description will be given of the present disclosure.

### Metal Ions

The polishing composition for semiconductor processing, according to the embodiments of the present disclosure, may include a first metal ion that is an alkali metal ion and abrasive particles that exhibit a positive charge on the surface to further improve the dispersibility of the abrasive particles.

Unlike other metal ions, alkali metal ions are not highly reactive in the polishing composition and may not readily form metal oxides on the polishing target surface during the polishing process. When alkali metal ions are applied to the polishing composition, an electrostatic repulsive force is formed between the alkali metal ions and the surface positively charged abrasive particles, which can improve the dispersibility of the polishing composition through the alkali metal ions.

Alkali metal ions may be monovalent elements and may be selected from the group consisting of lithium ions, sodium ions, potassium ions, rubidium ions, cesium ions, and francium ions.

The polishing composition for semiconductor processing may have a first metal ion content of 15 ppm (by weight) to 100 ppm (by weight). The first metal ion content may be 20 ppm (by weight) or more. The first metal ion content may be greater than or equal to 25 ppm (by weight). The first metal ion content may be greater than or equal to 28 ppm (by weight). The first metal ion content may be greater than or equal to 32 ppm (by weight). The first metal ion content may be 70 ppm or less (by weight). The first metal ion content may be 60 ppm or less (by weight). The first metal ion content may be 50 50 ppm or less (by weight). In such a case, the dispersibility of the abrasive particles can be effectively improved. Furthermore, excessive adsorption of a substantial number of the first metal ions on the polishing target surface may be inhibited, thereby preventing deterioration of the electrical properties of the device or excessive degradation of abrasive properties of the polishing composition on the polishing target surface.

The polishing composition for semiconductor processing may include a second metal ion, which is any one selected from the group consisting of iron ions, copper ions, nickel ions, aluminum ions, calcium ions, zinc ions, and combinations thereof.

The ratio of the content (by weight) of the second metal ions in the polishing composition to the content (by weight) of the first metal ions may be 15 or more.

Since the second metal ion has a relatively high reactivity, it may contribute to control the abrasive properties of the polishing composition on the tungsten film. However, the metal ions may react with other compounds during polishing and cleaning processes, etc. to easily form deposits on the polishing target surface, and the metal ions may adsorb on the surface of the substrate and degrade the electrical properties of the device to be manufactured. Embodiments may adjust the ratio of the content of the first metal ion to the content of the second metal ion to reduce the frequency of defects forming on the substrate surface below a certain level, while effectively improving the dispersibility and polishing properties of the polishing composition.

The ratio of the amount of the first metal ion (by weight) to the amount of the second metal ion (by weight) of the polishing composition may be 15 or more. The ratio may be 20 or more. The ratio may be 25 or more. The ratio may be 30 or more. The ratio may be 35 or more. The ratio may be 40 or more. The ratio may be 100 or less. The ratio may be 80 or less. The ratio may be 60 or less. The ratio may be 50 or less . In such a case, yield degradation of the device due to addition of the metal ions may be stably suppressed.

The polishing composition may contain no more than 1.3 ppm (by weight) of the second metal ion. The polishing composition may comprise no more than 1.2 ppm (by weight) of the second metal ion. The polishing composition may comprise 1 ppm or less (by weight) of the second metal ion. The polishing composition may comprise more than 0.01 ppm (by weight) of the second metal ion. In this case, the abrasive properties of the tungsten film can be controlled within a suitable range, while effectively suppressing contamination of the polishing target surface by metal ions.

The metal ion content of the polishing composition is measured by Inductively Coupled Plasma-Optical Emission Spectroscopy (ICP-OES).

### Abrasive Particles

The polishing composition may include abrasive particles.

The abrasive particles may include metal oxide particles and/or silicon oxide particles. The abrasive particles may include silica. The abrasive particles may include colloidal silica.

The abrasive particles may contain at least 70 wt% of colloidal silica based on the total weight of the abrasive particles. The abrasive particles may contain at least 80 wt% of colloidal silica. The abrasive particles may comprise at least 90 wt% of colloidal silica. The abrasive particles may be colloidal silica.

Abrasive particles may exhibit a positive surface charge. The abrasive particles with "positive surface charge" may mean abrasive particles that have a positive zeta potential in the polishing composition. Specifically, the abrasive particles with positive surface charge may be abrasive particles that has a positive zeta potential at a pH of 2 to 5.5.

Abrasive particles with a positive surface charge can exhibit good dispersibility due to electrostatic interaction with first metal ions. In addition, these particles may have the property of easily contacting the surface of a negatively charged silicon oxide film. In this way, abrasive particles may impart enhanced abrasive properties to the silicon oxide film in the polishing composition.

The abrasive particles may have a zeta potential of +10 mV to +50 mV at pH 2 to 5.5. The zeta potential may be greater than or equal to +15 mV. The zeta potential may be greater than or equal to +20 mV. In such a case, the abrasive particles may be readily dispersed due to interaction with the first metal ions, and the polishing composition may have good polishing rate on the silicon oxide film.

The zeta potential of the abrasive particles is measured with a particle size analyzer. An exemplary particle size analyzer is the Nano-ZS model from Malvern.

The abrasive particles may be surface-modified so that the surface is positively charged. The abrasive particles may be surface-modified with a compound having an amine group. Abrasive particles with modified surface by a compound having an amine group means that the abrasive particles are surface-modified not only by a compound having an amine group, but also by applying a compound having an amine group and another compound together.

The abrasive particles may be surface-modified with a compound including an amino silane. The abrasive particles may be surface-modified with an amino silane.

For example, the amino silanes may be 3-aminopropyltriethoxysilane, bis[(3-triethoxysilyl)propyl]amine, 3-aminopropyltrimethoxysilane, bis[(3-trimethoxysilyl)propyl]amine, 3-Aminopropylmethyldiethoxysilane, 3-Aminopropylmethyldimethoxysilane, N-[3-(trimethoxysilyl)propyl]ethylenediamine, N-bis[3-(trimethoxysilyl)propyl]-1,2-ethylenediamine, N-[3-(triethoxysilyl)propyl]ethylenediamine, diethylenetriaminopropyltrimethoxysilane, diethylenetriaminopropylmethyldimethoxysilane, diethylaminomethyltriethoxysilane, diethylaminopropyltrimethoxysilane, diethylaminopropyltriethoxysilane, dimethylaminopropyltrimethoxysilane, N-[3-(trimethoxysilyl)propyl]butylamine, and combinations thereof.

The polishing composition for semiconductor processing may contain from 15 ppm (by weight) to 200 ppm (by weight) of amino silane based on the total weight of the polishing composition. The polishing composition for semiconductor processing may include 20 ppm by weight or more of amino silane. The polishing composition for semiconductor processing may include 25 ppm or more by weight of amino silane. The polishing composition for semiconductor processing may include 30 ppm or more by weight of amino silane. The polishing composition for semiconductor processing may include 150 ppm or less by weight of amino silane. The polishing composition for semiconductor processing may include 100 ppm or less by weight of amino silane. The polishing composition for semiconductor processing may include 70 ppm or less by weight of amino silane. The polishing composition for semiconductor processing may include 50 ppm or less by weight of amino silane. In such cases, the electrostatic force of attraction between the abrasive particles and the first metal ion may be adjusted to a suitable strength. At the same time, the polishing composition may have a better polishing rate on the silicon oxide film.

The polishing composition for semiconductor processing may include from 1 wt% to 10 wt% of abrasive particles based on the total weight of the polishing composition. The polishing composition for a semiconductor process may include at least 2 wt% of abrasive particles. The polishing composition for a semiconductor process may include less than or equal to 8 wt% of abrasive particles. The polishing composition for a semiconductor process may include 5 wt% or less of abrasive particles. In such a case, the polishing composition may have an excellent polishing rate on the polishing target surface, while reliably inhibiting agglomeration of the abrasive particles.

The abrasive particles may have an average particle diameter of 20 nm or more. The particle diameter may be 30 nm or more. The particle diameter may be 40 nm or more. The particle diameter may be 70 nm or less. The particle diameter may be 60 nm or less. The particle diameter may be 50 nm or less. In such cases, the polishing composition may exhibit a good polishing rate on the polishing target surface, while stably controlling the frequency of defects on the polishing target surface.

The average particle diameter means the average particle diameter of the primary particles of the abrasive particles.

### Properties of Polishing Compositions

The pH of the polishing composition for semiconductor processing may be from 2 to 5.5. The pH may be greater than or equal to 2.5. The pH may be 3 or more. The pH may be greater than or equal to 3.5. The pH may be 5 or less. In such a case, the abrasive particles may have a relatively strong positive charge and disperse more readily. Further, the polishing composition may exhibit a polishing speed above a certain level with respect to the silicon oxide film.

The pH of the polishing composition is measured with a pH meter.

The zeta potential of the polishing composition for semiconductor processing may be from +10 mV to +50 mV. The zeta potential may be greater than or equal to +15 mV. The zeta potential may be greater than or equal to +20 mV. In such a case, the frequency of scratches on the polishing target surface may be effectively reduced due to agglomeration of the abrasive particles or adsorption of the abrasive particles on the polishing target surface.

The zeta potential of the polishing composition is measured with a particle size analyzer. An exemplary particle size analyzer is the Nano-ZS model from Malvern.

The electrical conductivity of the polishing composition for semiconductor processing may be from 10 µS/cm to 300 µS/cm. The electrical conductivity may be 20 µS/cm or more. The electrical conductivity may be 30 µS/cm or more. The electrical conductivity may be greater than or equal to 40 µS/cm. The electrical conductivity may be greater than or equal to 50 µS/cm. The electrical conductivity may be 200 µS/cm or less. The electrical conductivity may be 150 µS/cm or less. The electrical conductivity may be 120 µS/cm or less. In such a case, the number of first metal ions contained in the polishing composition may be adjusted to effectively suppress agglomeration of abrasive particles, while suppressing excessive corrosion of the metal wiring formed on the polishing target surface during the polishing process.

The polishing composition for semiconductor processing may have a viscosity at 25 °C of 0.8 cP to 2.0 cP. The viscosity may be 0.9 cP or more. The viscosity may be 1.5 cP or less. The viscosity may be 1.2 cP or less. In such a case, excessive agglomeration between components in the polishing composition can be suppressed, thereby effectively suppressing the occurrence of defects such as scratches on the polishing target surface.

The viscosity of the polishing composition is measured with a viscometer.

### Composition of the Polishing Composition

### Fluorinated Surfactants

The polishing composition for semiconductor processing of an embodiment may further include a fluorinated surfactant. The surfactant may attach to the silicon oxide film and effectively inhibit the strong adsorption of positively charged abrasive particles on the surface to the oxide film. Furthermore, the surfactant may attach to organic particles and help facilitate discharge of the particles.

The fluorinated surfactant may be a fluoroalkyl alkylene oxide-based compound. The fluorinated surfactant may be a compound according to Formula 1 below:

[Formula 1]. R_{f}-(Rₑₙ-O)ₙ-H

In Formula 1 above, R_{f} is a fluoroalkyl group having a carbon number from 3 to 10, Rₑₙ is an alkylene group having a carbon number from 2 or 3, and n is an integer from 2 to 15.

In Formula 1 above, R_{f} may be a perfluoroalkyl group having a carbon number of 3 to 10.

The fluorinated surfactant may be a polymeric surfactant. The fluorinated surfactant may have a weight average molecular weight of 150 g/mol to 3,000 g/mol. The weight average molecular weight may be 300 g/mol or more. The weight average molecular weight may be 500 g/mol or more. The weight average molecular weight may be 2,500 g/mol or less. The weight average molecular weight may be 2,000 g/mol or less. The weight average molecular weight may be 1,500 g/mol or less.

Fluorinated surfactants with the above characteristics have a controlled main chain length, which allows them to adhere efficiently to the surface of the silicon oxide film. Furthermore, the surfactant prevents excessive deterioration of the dispersibility of the polishing composition.

The weight average molecular weight of polymeric surfactants is measured by gel permeation chromatography (GPC).

Embodiments may adjust the content of the fluorinated surfactant within a predetermined range. This allows for inhibiting the adhesion of abrasive particles to the polishing target surface after polishing, while preventing excessive foaming of the polishing composition during the polishing process, which may compromise processability.

The polishing compositions for semiconductor processing may include 10 ppm or more (by weight) of fluorinated surfactants based on the total weight of the polishing composition. The polishing composition for semiconductor processing may include 20 ppm or more (by weight) of a fluorinated surfactant. The polishing composition for semiconductor processing may include 50 ppm or more (by weight) of a fluorinated surfactant. The polishing composition for semiconductor processing may include 100 ppm or more by weight of a fluorinated surfactant. The polishing composition for semiconductor processing may include 150 ppm or more (by weight) of a fluorinated surfactant. The polishing composition for semiconductor processing may include 500 ppm or less (by weight) of a fluorinated surfactant. The polishing composition for semiconductor processing may include 450 ppm or less (by weight) of a fluorinated surfactant. This may effectively inhibit the adsorption of abrasive particles on the oxide film, while inhibiting excessive foaming during the polishing process.

### Other Additives

The polishing composition for semiconductor processing may further include other additives. The additives are not limited to those commonly applied in the field of CMP. For example, the additive may be at least one of an oxidizing agent, an acid component, a pH modifier, a chelating agent, a dispersant, a polishing rate enhancer, a polishing modifier, a polishing pad protector, and a preservative.

The polishing composition for semiconductor processing may further include an oxidizing agent. The oxidizing agent oxidizes the metal, such as tungsten, to create an environment that more readily levels the substrate surface and improves polishing and etching speeds.

Oxidizers include hydrogen peroxide, urea peroxide, urea, percarbonate, periodic acid, periodate, perchloric acid, perchlorate, perchloric acid, perchlorate, perbromic acid, perbromate, perboric acid, perbromate, perborate, permanganic acid, permanganate, permanganate, persulfate, bromate, chlorate, chlorite, chromate, iodate, iodic acid, ammonium persulfate, benzoyl peroxide, calcium peroxide, barium peroxide, sodium peroxide, and peroxide.

The polishing composition for semiconductor processing may include from 0.01 wt% to 5 wt% of an oxidizing agent based on the total weight of the polishing composition. In such cases, the composition may exhibit good abrasive properties on the metal and may inhibit the formation of an oxide film on the metal to be polished during the polishing process.

The polishing composition for semiconductor processing may further include an acid component. The acid component may be, for example, hydrochloric acid, phosphoric acid, sulfuric acid, hydrofluoric acid, bromic acid, iodic acid, formic acid, malonic acid, maleic acid, maleic acid, oxalic acid, acetic acid, acetic acid, citric acid, adipic acid, adipic acid, acetic acid, acetic acid, propionic acid, fumaric acid, lactic acid, salicylic acid, pimelin, benzoic acid, succinic acid, phthalic acid, butyric acid, glutaric acid, glutamic acid, glutamine acid, glycolic acid, lactic acid, asparagine acid, tartaric acid, and salts thereof.

The polishing composition for semiconductor processing may further include a pH adjuster in addition to the acid component. The pH adjuster may be, for example, any one selected from the group consisting of ammonia, aminomethylpropanol, tetramethylammonium hydroxide, potassium hydroxide, sodium hydroxide, magnesium hydroxide, magnesium hydroxide, rubidium hydroxide, cesium hydroxide, sodium bicarbonate, sodium carbonate, and combinations thereof.

A polishing composition for semiconductor processing may include a chelating agent. The chelating agent may prevent polished metal particles from adsorbing on the polishing target surface.

A chelating agent may contain two or more carboxylic or alcoholic groups in its molecule. Two or more types of chelating agents including two or more carboxyl groups or alcohol groups in a molecule may be applied as chelating agents. Specifically, the chelating agent may include any one selected from the group consisting of ethylenediaminetetraacetic acid (EDTA), glycine, carboxylic acids, and combinations thereof. The compound having "carboxylic acid group" may mean a compound including at least one or more carboxyl groups in the molecule.

The polishing composition for semiconductor processing may further include a dispersant.

The dispersant may prevent agglomeration and uniformly disperse the abrasive particles within the polishing composition. Cationic dispersants may positively increase the zeta potential of the polishing composition, while anionic dispersants may negatively decrease the zeta potential of the polishing composition.

Dispersants may include anionic small molecules, cationic polymers, organic acids, and the like.

The anionic small molecule of the dispersant may be one or more selected from oxalic acid, citric acid, polysulfonic acid, polyacrylic acid, polymethacrylic acid, and combinations thereof.

The cationic polymer of the dispersant may be one or more selected from polylysine, polyethyleneimine, benzethonium chloride, bronidox, cetrimonium bromide, cetrimonium chloride, dimethyldioctadecylammonium chloride, tetramethylammonium hydroxide, distearyldimethylammonium chloride, polyarylamine, and combinations thereof.

The organic acid in the dispersant may be one or more selected from hydroxylbenzoic acid, ascorbic acid, picolinic acid, glutamic acid, tryptophan, aminobutyric acid, and combinations thereof.

The polishing rate enhancer is an additive for increasing the polishing rate of the substrate or wiring to be polished, and may be one or more selected from potassium nitrate, iron nitrate, ammonium hydroxide, citric acid, acetic acid, and combinations thereof.

The polishing modifier is intended to minimize adsorption of the polishing composition to the metal surface and may include ammonium compounds, potassium nitrate, amino acids, salts thereof, and the like.

The polishing composition for a semiconductor process may include a solvent. The solvent may be water, and more particularly may be ultrapure water.

### Abrasive Properties of Polishing Compositions

The polishing rate for the silicon oxide film of the polishing composition for semiconductor processing may be 950 Å/min or more. The polishing rate may be 1000 Å/min or more. The polishing rate may be 1100 Å/min or more. The polishing rate may be 3000 Å/min or less. The polishing rate may be 2500 Å/min or less. The polishing rate may be 2000 Å/min or less.

The polishing rate for the tungsten film of the polishing composition for semiconductor processing may be 70 Å/min or more. The polishing rate may be 500 Å/min or less. The polishing rate may be 300 Å/min or less. The polishing rate may be 200 Å/min or less.

The polishing selectivity ratio of the silicon oxide film to the tungsten film in the polishing composition for semiconductor processing may be 5 or more. The polishing selectivity ratio may be 6 or more. The polishing selectivity ratio may be 7 or more. The polishing selectivity ratio may be 15 or less.

In this case, the polishing composition may exhibit excellent silicon oxide film polishing rate selectivity ratio compared to tungsten polishing rate.

The Ra value of the tungsten film measured after 30 seconds of polishing with the polishing composition for semiconductor processing may be 1 nm or less. The Ra value may be 0.9 nm or less. The Ra value may be 0.8 nm or less. The Ra value may be greater than or equal to 0.1 nm. The polishing compositions having these characteristics may provide a tungsten film that is less damaged by corrosion when applied for polishing.

Ra values are measured with an Atomic Force Microscope (AFM) based on ISO 4287.

Polishing of each thin film is performed at a pressure of 2.2 psi, carrier speed of 87 rpm, platen speed of 93 rpm, and slurry flow rate of 250 ml/min. The polishing pad is the SR-300 model from SK enpulse Co., Ltd.

To measure the polishing rate of each thin film, a polishing machine may be used, for example, the AP-300 model from CTS.

### Method of Manufacturing the Substrate

The method of manufacturing a substrate of the embodiment includes polishing the substrate by applying the polishing composition for semiconductor processing as a slurry.

The substrate may include at least one of an insulating film, metallized wiring, and a barrier layer on the top surface. The metallic wiring may include copper or tungsten. If the metallic wiring includes copper, the barrier layer may include tantalum and nitrides thereof. If the metallic wiring includes tungsten, the barrier layer may include titanium and nitrides thereof.

Specifically, the process of polishing a substrate may be performed by contacting the substrate to be polished with the polishing composition for semiconductor processing supplied from a spray nozzle onto a polishing pad, while the polishing head holding the substrate is rotated and the tablet, to which the polishing pad is attached, is also rotated.

The process of polishing the substrate may further include, if desired, conditioning the surface of the polishing pad prior to polishing.

The polishing composition for semiconductor processing may polish wafers that come into contact with the polishing pad as they penetrate toward the substrate.

In the process of polishing the substrate, a pressure of 6.89 kPa to 48.26 kPa may be applied. The pressure may be from 13.79 kPa to 34.47 kPa.

The process of polishing the substrate may last from 50 seconds to 10 minutes. However, this can vary depending on the degree of polishing user is aiming for.

The detailed description of the polishing composition for semiconductor processes is already discussed above and is therefore omitted.

The method of manufacturing the substrate may further incude a washing process to clean the polished substrate.

The cleaning process may be carried out by washing the polished substrate through purified water and inert gas.

Specific embodiments will be described in more detail below. The following embodiments are illustrative only to aid in understanding the invention and are not intended to limit the scope of the invention.

### Manufacturing Example: Preparation of Polishing Compositions

For each example and comparative example, about 5 wt% of colloidal silica surface-modified with 150 ppm (by weight) of (3-aminopropyl) triethoxysilane, 2 wt% of sorbitol, 0.001 wt% to 0.005 wt% of 1,2-benzisothiazol-3(2H)-one, and the metal ions listed in Table 1 below were mixed in ultrapure water as abrasive particles to prepare a total of 100 wt% of the polishing composition.

The abrasive particles content, average abrasive particles diameter, and metal ion content of the polishing compositions of each of the embodiments and comparative examples are shown in Table 1 below. The metal ion content listed in Table 1 corresponds to the metal ion specific content of the polishing composition as measured by Inductively Coupled Plasma (ICP).

The pH, zeta potential, electrical conductivity, and viscosity at 25 °C measured for the polishing compositions of each example and comparative example are listed in Table 2 below.

### Evaluation Example: Measuring and Evaluating Polishing Properties

The polishing composition was applied, and the top surface of the 300 mm diameter wafer was polished on a CTS AP-300 polishing machine.

The polishing was performed at a polishing time of 60 seconds, pressure of 2.2 psi, carrier speed of 93 rpm, platen speed of 87 rpm, and slurry flow rate of 300 ml/min.

The wafer including a tungsten pattern with a pattern density of 50 % and a silicon oxide film, was applied.

After polishing, the difference in thickness between the silicon oxide film and the tungsten film before and after polishing was measured to calculate the polishing rate for each thin film in the polishing composition and the polishing selectivity ratio of the silicon oxide film to the tungsten film.

In addition, the Ra value of the tungsten film on the substrate surface after polishing was measured by Atomic Force Microscopy (AFM) according to ISO 4287.

The measurements for each Example and Comparative Example are listed in Table 3 below.

**[Table 1]**

| | | Example 1 | Example 2 | Example 3 | Example 4 | Comparati ve Example 1 | Comparati ve Example 2 |
|---|---|---|---|---|---|---|---|
| Abrasive Particles Content (wt%) | | 5 | 5 | 5 | 5 | 6 | 5 |
| Average Abrasive Particle Diameter (nm) | | 44.68 | 44.75 | 44.49 | 44.68 | 44.23 | 44.68 |
| First Metal Ion | Lithium Ion Content | 0.001 | 0.000 | 0.001 | 0.000 | 0.001 | 0.003 |
| | (ppm, by weight) | | | | | | |
| | Sodium Ion Content | 0.245 | 0.261 | 0.162 | 0.133 | 0.261 | 0.015 |
| | (ppm, by weight) | | | | | | |
| | Potassium Ion Content | 36.213 | 29.610 | 29.962 | 30.143 | 118.753 | 0.007 |
| | (ppm, by weight) | | | | | | |
| | Total | 36.459 | 29.872 | 30.125 | 30.276 | 119.015 | 0.025 |
| | (ppm, by weight) | | | | | | |
| Second Metal Ion | Iron Ion Content | 0.000 | 0.232 | 0.141 | 0.104 | 0.069 | 0.002 |
| | (ppm, by weight) | | | | | | |
| | Copper Ion Content | 0.007 | 0.005 | 0.054 | 0.005 | 0.016 | 0.021 |
| | (ppm, by weight) | | | | | | |
| | Nickel Ion Content | 0.000 | 0.001 | 0.000 | 0.000 | 0.000 | 0.004 |
| | (ppm, by weight) | | | | | | |
| | Aluminum Ion Content | 0.640 | 0.693 | 0.845 | 0.903 | 0.095 | 0.011 |
| | (ppm, by weight) | | | | | | |
| | Calcium Ion Content | 0.108 | 0.003 | 0.170 | 0.006 | 1.241 | 0.004 |
| | (ppm, by weight) | | | | | | |
| | Zinc Ion Content | 0.057 | 0.000 | 0.000 | 0.000 | 0.000 | 0.000 |
| | (ppm, by weight) | | | | | | |
| | Total | 0.812 | 0.934 | 1.209 | 1.019 | 1.421 | 0.043 |
| | (ppm, by weight) | | | | | | |
| Ratio of First Metal Ion Content to Second Metal Ion Content | | 44.88 | 31.99 | 24.92 | 29.72 | 83.75 | 0.57 |

**[Table 2]**

| | Example 1 | Example 2 | Example 3 | Example 4 | Comparativ e Example 1 |
|---|---|---|---|---|---|
| pH | 4.19 | 4.14 | 4.21 | 4.18 | 4.05 |
| Zeta Potential (mV) | 25.13 | 25.77 | 22.03 | 22.63 | 25.20 |
| Electrical Conductivity (µS/cm) | 59.38 | 66.04 | 33.52 | 35.60 | 618.50 |
| Viscosity (cP) | 1.024 | 1.027 | 1.036 | 1.074 | 1.033 |

**[Table 3]**

| | Polishing Rate of Tungsten (Å/min) | Polishing Rate of Silicon Oxide Film (Å/min) | Polishing Selectivity Ratio of Silicon Oxide Film to Tungsten Film | Ra Values of The Tungsten Films (nm) |
|---|---|---|---|---|
| Example 1 | 152 | 1281 | 8.4 | 0.77 |
| Example 2 | 133 | 1154 | 8.7 | 0.78 |
| Example 3 | 130 | 1109 | 8.5 | 0.76 |
| Example 4 | 143 | 1129 | 7.9 | 0.78 |
| Comparati ve Example 1 | 127 | 940 | 7.4 | 1.08 |
| Comparati ve Example 2 | 65 | 1010 | 15.5 | 1.02 |

In Table 3 above, the Ra values of the tungsten films of Examples 1 to 4 were measured to be less than or equal to 0.8 nm, while the Ra values of the tungsten films of Comparative Examples 1 and 2 were measured to be greater than 1 nm. This means that Examples 1 to 4, in which the metal ion content are controlled within a predetermined range in the embodiments, may provide a smoother polishing target surface compared to the comparative examples.

With respect to the polishing rate of the silicon oxide film, Examples 1 to 4 showed higher values than Comparative Example 1. This means that the abrasive properties of the polishing composition on the silicon oxide film are reduced when the first metal ion is excessively included in the polishing composition.

In terms of tungsten film polishing rate, Comparative Example 2 shows significantly lower values compared to Examples 1 to 4. This means that the second metal ion contributes to the improvement of the abrasive properties of the polishing composition on the tungsten film.

While this disclosure includes specific examples, it will be apparent after an understanding of the disclosure of this application that various changes in form and details may be made in these examples without departing from the spirit and scope of the claims and their equivalents. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents. Therefore, the scope of the disclosure is defined not by the detailed description, but by the claims and their equivalents, and all variations within the scope of the claims and their equivalents are to be construed as being included in the disclosure.

## Claims

1. A polishing composition for semiconductor processing comprising abrasive particles and a first metal ion, which is an alkali metal ion,
wherein the abrasive particles have surface positive charges, and
wherein an amount of the first metal ion is 15 ppm (by weight) to 100 ppm (by weight).

2. The polishing composition of claim 1, wherein the alkali metal ion is monovalent ion selected from the group consisting of lithium ions, sodium ions, potassium ions, rubidium ions, cesium ions, and francium ions.

3. The polishing composition of claim 1, further comprising a second metal ion selected from the group consisting of iron ions, copper ions, nickel ions, aluminum ions, calcium ions, and zinc ions.

4. The polishing composition of claim 3, wherein a ratio of an amount (by weight) of the second metal ion to the amount (by weight) of the first metal ion is 15 or more.

5. The polishing composition of claim 1, wherein the abrasive particles have a zeta potential of +10 mV to +50 mV at a pH of 2 to 5.5.

6. The polishing composition of claim 1, wherein the abrasive particles are surface-modified with a compound having an amine group.

7. The polishing composition of claim 1, wherein the abrasive particles are surface-modified with a compound having an amino silane selected from the group consisting of 3-aminopropyltriethoxysilane, bis[(3-triethoxysilyl)propyl]amine, 3-aminopropyltrimethoxysilane, bis[(3- trimethoxysilyl)propyl]amine, 3-Aminopropylmethyldiethoxysilane, 3-Aminopropylmethyldimethoxysilane, N-[3-(trimethoxysilyl)propyl]ethylenediamine, N-bis[3-(trimethoxysilyl)propyl]-1,2-ethylenediamine, N-[3-(triethoxysilyl)propyl]ethylenediamine, diethylenetriaminopropyltrimethoxysilane, diethylenetriaminopropylmethyldimethoxysilane, diethylaminomethyltriethoxysilane, diethylaminopropyltrimethoxysilane, diethylaminopropyltriethoxysilane, dimethylaminopropyltrimethoxysilane, and N-[3-(trimethoxysilyl)propyl]butylamine.

8. The polishing composition of claim 1, wherein the polishing composition comprises the abrasive particles in an amount of 1 wt% to 10 wt% based on a total weight of the polishing composition.

9. The polishing composition of claim 1, wherein the abrasive particles have an average particle diameter of 20 nm or more.

10. The polishing composition of claim 1, wherein the polishing composition have an electrical conductivity of 10 µS/cm to 300 µS/cm.

11. The polishing composition of claim 1, further comprising a fluorinated surfactant.

12. The polishing composition of claim 11, wherein the fluorinated surfactant is a fluoroalkyl alkylene oxide-based compound of Formula 1:
[Formula 1] R_{f}-(Rₑₙ-O)ₙ-H
where, in Formula 1 above, R_{f} is a fluoroalkyl group having a carbon number from 3 to 10, Rₑₙ is an alkylene group having a carbon number from 2 or 3, and n is an integer from 2 to 15.

13. The polishing composition of claim 11, wherein the polishing composition comprises 10 ppm (by weight) to 500 ppm (by weight) of the fluorinated surfactant.

14. The polishing composition of claim 1, wherein the polishing composition has a viscosity of 0.8 cP to 2.0 cP at 25°C.

15. The polishing composition of claim 11, wherein the fluorinated surfactant has a weight average molecular weight of 150 g/mol to 3,000 g/mol.

16. The polishing composition of claim 1, further comprising an additive selected from the group consisting of an oxidizing agent, an acid component, a pH modifier, a chelating agent, a dispersant, a polishing rate enhancer, a polishing modifier, a polishing pad protector, and a preservative.

17. A method of manufacturing a substrate comprising polishing the substrate by applying the polishing composition of claim 1 as a slurry.

18. The method of claim 17, wherein the polishing comprises:
contacting the substrate with a polishing pad and the polishing composition supplied from a spray nozzle; and
rotating a polishing head fixing the substrate and a platen, to which the polishing pad is attached.

19. The method of claim 17, wherein during the polishing, a pressure of 6.89 kPa to 48.26 kPa is applied to the substrate.

20. The method of claim 17, wherein the substrate comprises at least one of an insulating film, metallized wiring, and a barrier layer.
